# EUROPÄISCHE PATENTANMELDUNG

(11) **EP 2 818 877 A1**
(43) Veröffentlichungstag der Anmeldung: **31.12.2014**
(21) Anmeldenummer: 14169474.5
(22) Anmeldetag: 22.05.2014
(51) Int. Cl.: G01R 15/14

(54) **Verfahren und Vorrichtung zur Ermittlung einer Gleichspannung in einem galvanisch isolierten System**

(30) Priorität: 19.06.2013 DE 102013211449
(71) Anmelder: ROBERT BOSCH GMBH, 70442 Stuttgart (DE)
(72) Erfinder: Brenner, Markus, 72622 Nürtingen (DE); Schiemann, Werner, 70734 Fellbach (DE); Mollenkopf, Wolfgang, 72793 Pfullingen (DE)

(57) **Zusammenfassung**

Es werden eine Vorrichtung sowie ein Verfahren zum Ermitteln einer Gleichspannung eines galvanisch isolierten Systems vorgeschlagen. Dabei wird ein erstes Signal mit einer Frequenz proportional einer Gleichspannung auf einer Hochvolt (HV)-Seite des Systems erzeugt. Anschließend wird das erzeugte erste Signal galvanisch isoliert auf eine Niedervolt (LV)-Seite des Systems übertragen und die Gleichspannung aus der Frequenz des übertragenen Signals ermittelt.

## Beschreibung

### Stand der Technik

Die vorliegende Erfindung betrifft ein Verfahren und eine Vorrichtung zum Ermitteln einer Gleichspannung in einem galvanisch isolierten Hochvolt-System. Insbesondere betrifft die vorliegende Erfindung Verbesserungen hinsichtlich des Aufbaus und des Betriebs einer entsprechenden Vorrichtung.

Eine galvanisch getrennte Spannungsmessung wird vor allem beim Betrieb von Systemen mit hohen Spannungen benötigt. Im Rahmen der vorliegenden Erfindung sollen unter "hohen Spannungen" solche Spannungen verstanden werden, welche beim Betrieb elektrisch antreibbarer Fahrzeuge (EV/HEV) sowie beim Betrieb photovoltaischer Systeme auftreten. Für solche Systeme existieren Normen und Vorschriften, die eine galvanische Trennung zwischen Hochvolt-und Niedervoltteil fordern. Die Spannungsmessung auf der Hochvoltseite ist z.B. erforderlich, um eine Anzeige der Berührspannung zu realisieren. Das heißt, dass der Benutzer informiert werden muss, wenn die Spannung lebensgefährliche Werte annimmt. Diese Eigenschaft weisen elektrische Gleichspannungen größer 60 V (DC) auf. In der Leistungselektronik von Hybrid-und Elektrofahrzeugen treten beispielsweise derzeit Spannungen von ca. 500 V DC auf. In Solarsystemen bzw. Photovoltaiksystemen betragen die Spannungen derzeit bis ca. 1000 V DC. Bekannte Realisierungen enthalten Spannungsteiler, bestehend aus Widerständen, die die hohe Spannung auf ein Logik-kompatibles Niveau herunterteilen (z.B. 5 V, 3,3 V). Anschließend wird diese Kleinspannung durch analoge und/oder digitale Signalverarbeitung über ein Übertragungselement (z.B. Optokoppler, kapazitiv, induktiv), auf die Niedervoltseite übertragen und dort weiterverarbeitet. Allen diesen Lösungen ist gemeinsam, dass sie auf der Seite der Messung (also der Hochvolt-Seite) eine aufwändige und teuere Hilfsspannungsversorgung, sowie eine Signalverarbeitung benötigen.

### Offenbarung der Erfindung

Im Rahmen der vorliegenden Erfindung wird daher ein Verfahren zur Ermittlung einer Gleichspannung eines galvanisch isolierten Systems mit den folgenden Schritten vorgeschlagen: Zunächst wird ein erstes Signal mit einer Frequenz proportional der Gleichspannung auf einer Hochvolt(HV)-Seite des Systems erzeugt. Die Hochvolt-Seite kann dabei beispielsweise ein Hochvolt (HV)-Bordnetz eines elektrisch antreibbaren Fortbewegungsmittels sein. Anschließend wird das erste Signal galvanisch getrennt auf eine Niedervolt-Seite des Systems übertragen. Diese galvanische Trennung ermöglicht eine Isolierung, welche der Sicherheit dient und gesetzlichen Vorschriften genügt. Anschließend wird die Gleichspannung aus der Frequenz des übertragenen Signals ermittelt. Die Erfindung realisiert diese Messung unter Verwendung sehr weniger, preiswerter Bauteile und ohne die Notwendigkeit einer Hilfsspannung auf der Seite der Messung. Dabei wird die zu messende Spannung beispielsweise mit Hilfe eines einfachen spannungsgesteuerten Oszillators (voltage controlled oscillator, VCO) direkt in einen proportionalen Takt umgewandelt, wobei dessen Frequenz proportional der gemessenen Spannung ist. Der spannungsgesteuerte Oszillator benötigt keinerlei Hilfsspannungsversorgung und keine weitere Signalverarbeitung auf der Hochspannungsseite, da er direkt aus der Hochspannung mit Energie versorgt wird.

Die Unteransprüche zeigen bevorzugte Weiterbildungen der Erfindung.

Bevorzugt wird zum Erzeugen des ersten Signals ausschließlich elektrische Energie der Hochvolt-Seite verwendet. Insbesondere kann die elektrische Energie direkt (und vollständig) der zu messenden Gleichspannung entnommen werden, um das erste Signal zu erzeugen. Optional kann dabei auch das galvanisch getrennte Übertragen unter Zuhilfenahme elektrischer Energie aus der Hochvolt-Seite erfolgen.

Gemäß einem weiteren Aspekt der vorliegenden Erfindung wird eine Vorrichtung zum Ermitteln einer Gleichspannung vorgeschlagen. Die Vorrichtung umfasst einen spannungsabhängigen Frequenzgenerator zum Erzeugen eines ersten Signals mit einer Frequenz proportional der Gleichspannung. Solche spannungsabhängigen Frequenzgeneratoren werden häufig auch als "voltage controlled oscillator" (VCO) bezeichnet. Weiter umfasst die Vorrichtung einen Übertrager zum galvanisch getrennten Übertragen des ersten Signals. Der Übertrager realisiert dabei eine galvanische Isolation der Hochvolt-Seite gegenüber der Niedervolt-Seite. Er kann beispielsweise optisch, kapazitiv, induktiv o.Ä. Signale unabhängig von einer galvanischen Verbindung der beiden Seiten übertragen. Zudem umfasst die Vorrichtung eine Signalverarbeitungseinheit zum Ermitteln der Gleichspannung aus der Frequenz des übertragenen ersten Signals, wobei der spannungsabhängige Frequenzgenerator eingerichtet ist, aus der Gleichspannung mit elektrischer Energie versorgt zu werden. Die Signalverarbeitungseinrichtung ist mit anderen Worten eingerichtet, eine Frequenzanalyse des übertragenen Signals vorzunehmen und anhand eines vordefinierten Proportionalitätsverhältnisses zwischen der Frequenz und der Gleichspannung die hochvoltseitige Gleichspannung zu signalisieren. Dies kann beispielsweise die Grundfrequenz des übertragenen ersten Signals berücksichtigen. Mit anderen Worten kann beispielsweise ein Taktsignal erzeugt und zur Ermittlung der Gleichspannung ausgewertet werden. Erfindungsgemäß ist es möglich, dass der spannungsabhängige Frequenzgenerator nicht ausschließlich mit dem Gleichspannungssignal als Signaleingang beaufschlagt wird, sondern eingerichtet ist, elektrische Energie zumindest teilweise aus der Hochvolt-Seite, insbesondere der zu messenden Gleichspannung, zu entnehmen. Die vorgenannten Erfindungsaspekte realisieren einen besonders einfachen Aufbau, einfache galvanische Isolationen zwischen der Hochvolt-Seite und der Niedervolt-Seite und daher eine kompakte Bauform bei kostengünstigem Aufbau und Betrieb mit hohem Wirkungsgrad.

Weiter bevorzugt ist der spannungsabhängige Frequenzgenerator eingerichtet, ausschließlich aus der Gleichspannung mit elektrischer Energie versorgt zu werden. Auf diese Weise kann eine Hilfsspannungsversorgung zum Betrieb des spannungsabhängigen Frequenzgenerators entfallen. Alternativ oder zusätzlich ist der Übertrager eingerichtet, ausschließlich aus der Hochvolt-seitigen Gleichspannung mit elektrischer Energie versorgt zu werden. Auf diese Weise entfällt auch für den Übertrager eine niedervoltseitige oder separat ausgeführte Spannungsversorgung für dessen Betrieb.

Bevorzugt ist der Übertrager dabei eingerichtet, das erste Signal kapazitiv und/oder induktiv und/oder optisch zu übertragen. Selbstverständlich kann der Übertrager je nach Ausführung auch passiv ausgeführt sein, so dass eine Spannungsversorgung (selbstverständlich abgesehen vom Messsignal) gänzlich entfallen kann.

Bevorzugt ist zumindest ein Eingang des spannungsabhängigen Frequenzgenerators eingerichtet, mit der zu messenden Gleichspannung beaufschlagt zu werden. Beim Vorhandensein mehrerer Eingänge können jedoch beispielsweise unterschiedliche hochvoltseitige Spannungssignale erfasst und in korrespondierende Wechselsignale gewandelt werden. Alternativ können mehrere Eingänge des spannungsabhängigen Frequenzgenerators dasselbe Gleichspannungssignal erfassen und diese über denselben Übertrager oder gar separate Übertrager auf eine Niedervolt-Seite des Systems wandeln. Dies bietet die Möglichkeit einer Konsolidierung bzw. Mitteilung des Messergebnisses auf der Niedervolt-Seite. Zusätzlich ist zumindest ein Ausgang des spannungsabhängigen Frequenzgenerators eingerichtet, ein Eingangssignal des Übertragers bereitzustellen. Wie vorstehend beschrieben, können mehrere Übertrager Verwendung finden, um mehrere Messergebnisse getrennt auf die Niedervolt-Seite zu übertragen. Dies ermöglicht eine Niedervolt-seitige Mittelung der gemessenen Spannungen bzw. der übertragenen Wechselsignale.

Weiter bevorzugt umfasst die Signalverarbeitungseinheit einen Mikrocontroller. Dieser kann das vom Übertrager ausgegebene Wechselsignal direkt als Eingangsgröße erhalten. Gängige Mikrocontroller sind bekanntlich im Stande, Eingangssignale hinsichtlich Spannung und Frequenz zu analysieren und bei Bedarf zusätzliche Verarbeitungsschritte (z.B. zur Signalaufbereitung) durchzuführen. Zudem bietet die Verwendung eines Mikrocontrollers die Möglichkeit, eine ereignisgesteuerte (z.B. messgrößenabhängige) Ausgabe vorzusehen, mittels welcher ein Anwender über die ermittelte Gleichspannung informiert wird.

Bevorzugt kann die erfindungsgemäße Vorrichtung zusätzlich eine Ausgabeeinheit umfassen, welche beispielsweise der Signalverarbeitungseinheit nachgeschaltet sein kann. Die Ausgabeeinheit ist eingerichtet, einen Anwender über die ermittelte Gleichspannung zu informieren bzw. beim Verlassen eines vordefinierten Gleichspannungsbereiches den Anwender zu alarmieren. Dies kann beispielsweise durch eine Anzeige ermittelter Werte, eine akustische Ausgabe und alternativ oder zusätzlich durch eine akustische oder optische Alarm-Funktion erfolgen.

Die Gleichspannung kann eine Hochvolt-Spannung im Bereich zwischen 300 V und 600 V, insbesondere 450 V bis 500 V, sein, wie sie beispielsweise im Bordnetz bzw. in den Energiespeichern eines elektrisch antreibbaren Fortbewegungsmittels auftritt. Alternativ oder zusätzlich kann die Hochvolt-Spannung einem Photovoltaik-Modul zugeordnet sein, welches elektromagnetische Strahlung in elektrische Spannung (z.B. im Bereich von ca. 1000 V DC) umwandelt.

Generell ist die Erfindung unabhängig vom Wert der DC-HV-Spannung, d.h., durch geeignete Wahl der Bauelemente ist jeder Spannungsbereich denkbar.

### Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:
- Figur 1: ein Blockschaltbild einer Vorrichtung zur galvanisch getrennten Messung einer Hochvolt-Spannung;
- Figur 2: ein Blockschaltbild eines Ausführungsbeispiels einer erfindungsgemäßen Vorrichtung zum Ermitteln einer Gleichspannung;
- Figur 3: ein Schaltbild eines alternativen Ausführungsbeispiels einer Vorrichtung gemäß der vorliegenden Erfindung mit Zeitsignalen einer Kondensatorspannung sowie eines Diodenstromes;
- Figur 4: ein Schaltbild zur Simulation eines Ausführungsbeispiels einer erfindungsgemäßen Vorrichtung;
- Figur 5: Zeitdiagramme zu elektrischen Größen der in Figur 4 dargestellten Vorrichtung;
- Figur 6: Diagramme zu Oszillatorfrequenz und Leistungsaufnahme in Abhängigkeit einer Versorgungsspannung;
- Figur 7: ein Schaltbild eines alternativen Ausführungsbeispiels einer erfindungsgemäßen Vorrichtung, welches aus einem astabilen Multivibrator abgeleitet ist;
- Figur 8: ein Schaltdiagramm zur Simulation eines alternativen Ausführungsbeispiels einer erfindungsgemäßen Vorrichtung; und
- Figur 9: ein Flussdiagramm, veranschaulichend Schritte eines Ausführungsbeispiels eines erfindungsgemäßen Verfahrens.

### Ausführungsformen der Erfindung

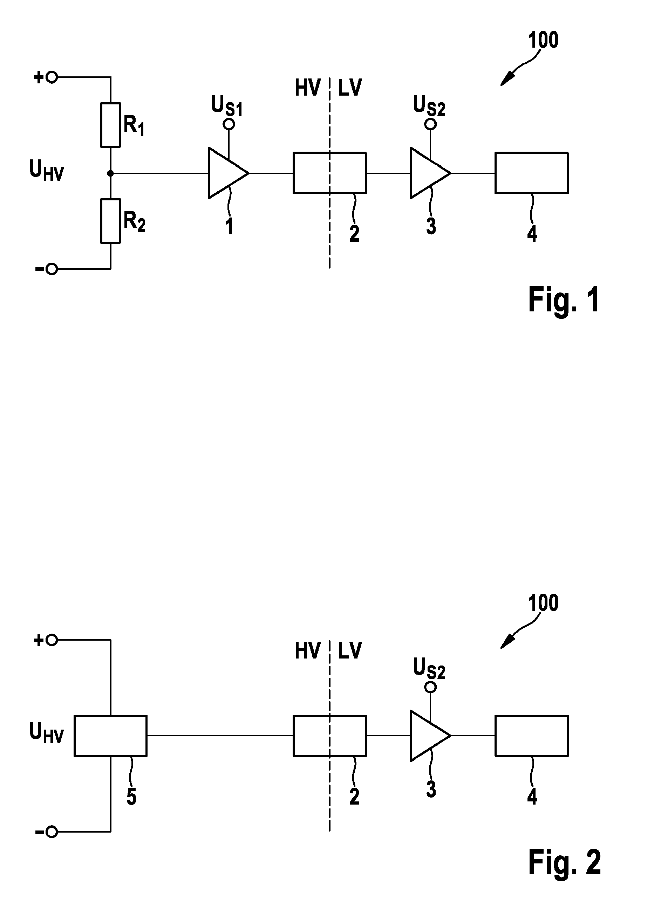

Figur 1 zeigt eine Vorrichtung 100, mittels welcher eine Hochvoltspannung U_{HV} galvanisch getrennt gemessen und auf einer Ausgabeeinheit 4 angezeigt werden soll. Ein die Ohmschen Widerstände R₁, R₂ umfassender Spannungsteiler teilt die zu messende Hochvolt-Gleichspannung U_{HV} auf ein ausgangsseitig Logik-kompatibles Spannungsniveau. Dieser Ausgang des Spannungsteilers dient als Eingang einer Signalverarbeitungseinheit 1, welche eine separate Energieversorgung bzw. Spannungsversorgung U_{S1} hat. Die Leistungsaufnahme der Signalverarbeitungseinheit 1 an ihrem Messeingang ist dabei zu vernachlässigen. Ausgangsseitig ist die Signalverarbeitungseinheit 1 mit einem Übertrager 2 elektrisch gekoppelt, mittels welchem eine galvanische Trennung der Hochvolt (HV)-Seite gegenüber der Niedervolt (LV)-Seite erzielt wird. Der Ausgang des Übertragers 2 wird einer niedervoltseitigen Signalverarbeitungseinheit 3 zugeführt, welche über eine separate Energie- bzw. Spannungsversorgung U_{S2} gespeist wird. Ausgangsseitig ist die Signalverarbeitungseinheit 3 mit der Ausgabeeinheit 4 gekoppelt, über welche einem Anwender der Vorrichtung 100 das Ergebnis der Spannungsmessung signalisiert wird. Es ist ein Vorteil eines Aspektes der vorliegenden Erfindung, dass die separate Versorgungsspannung der HV-seitigen Signalverarbeitungseinheit 1 entfallen kann.

Figur 2 zeigt eine erfindungsgemäße Ausgestaltung einer Vorrichtung 100 zum Ermitteln einer Hochvolt (HV)-Gleichspannung U_{HV}. Anstatt des Spannungsteilers R₁, R₂ (siehe Figur 1) ist in Figur 2 ein spannungsabhängiger Frequenzgenerator (voltage controlled oscillator, VCO) eingangsseitig direkt mit der Hochvolt-Spannung U_{HV} beaufschlagt. Ein mit der Hochvolt-Spannung U_{HV} korrespondierendes Wechselsignal wird vom spannungsabhängigen Frequenzgenerator 5 an die Hochvolt (HV)-Seite eines Übertragers 2 gesendet. Niedervolt (LV)-seitig gibt der Übertrager 2 das übertragene Wechselsignal an eine Signalverarbeitungseinheit 3 weiter, dessen Ausgangssignal einem Anwender mittels einer Ausgabeeinheit 4 zur Anzeige der gemessenen Spannung U_{HV} dargestellt wird. Erkennbar ist gegenüber der in Figur 1 dargestellten Vorrichtung 100 die in Figur 2 dargestellte Vorrichtung 100 unabhängig von einer separaten Hochvolt (HV)-seitigen Versorgungsspannung zur Erzeugung eines mittels des Übertragers 2 zu übertragenden Wechselsignals.

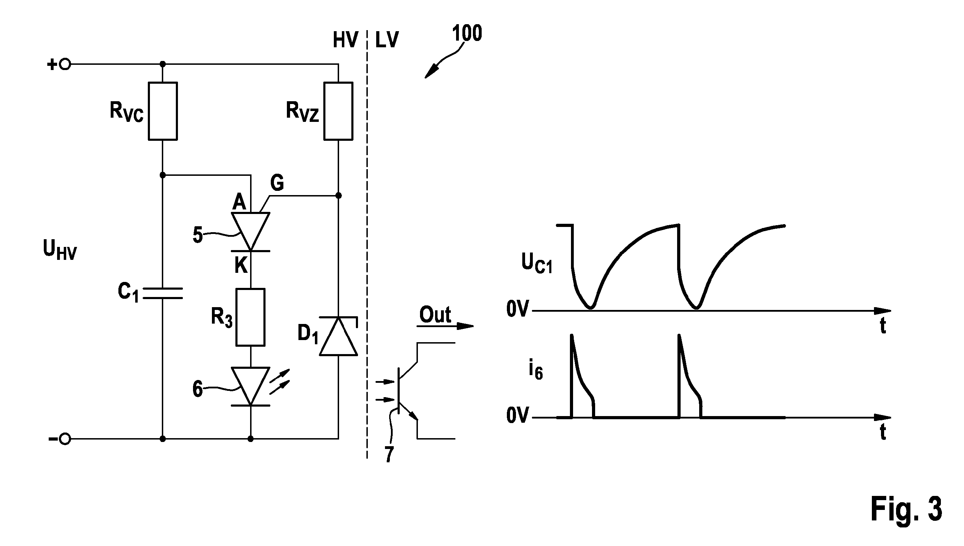

Figur 3 zeigt ein Schaltbild eines alternativen Ausführungsbeispiels einer erfindungsgemäßen Vorrichtung 100. An dem Pluspol + einer Hochvoltspannung U_{HV} ist ein erster Anschluss eines Ohmschen Widerstandes R_{VC} angeschlossen, dessen zweiter Anschluss mit einem ersten Anschluss einer Kapazität C₁ elektrisch verbunden ist. Ein zweiter Anschluss der Kapazität C₁ ist mit dem Minuspol - der Hochvoltspannung U_{HV} elektrisch verbunden. Zusätzlich ist der Pluspol + der Hochvoltspannung U_{HV} mit einem ersten Anschluss eines zweiten Ohmschen Widerstandes R_{VZ} verbunden. Ein zweiter Anschluss des zweiten Ohmschen Widerstandes R_{VZ} ist mit einer Zenerdiode (Z-Diode) D₁ elektrisch verbunden, deren zweiter Anschuss mit dem Minuspol - der Hochvoltspannung U_{HV} elektrisch verbunden ist. Der zweite Anschluss des Ohmschen Widerstandes R_{VC} ist mit einem ersten Anschluss A eines sogenannten Programmable Unijunction-Transistors (PUT) 5 verbunden. Der zweite Anschluss des zweiten Ohmschen Widerstandes R_{VZ} ist mit einem zweiten Eingang G des PUT 5 verbunden. Der Ausgang K des PUT 5 ist mit einem ersten Anschluss eines dritten Ohmschen Widerstandes R₃ elektrisch verbunden, dessen zweiter Anschluss mit einem ersten Anschluss einer LED 6 verbunden ist. Die LED 6 ist mit ihrem zweiten Anschluss ebenfalls minusseitig mit der Hochspannung U_{HV} verbunden. Ein Lichtsensor 7 ist eingerichtet, von der LED 6 ausgesendetes Licht in elektrische Signale zu wandeln. Die LED 6 stellt in Verbindung mit dem Lichtsensor 7 einen optischen Übertrager 2 dar. Die Z-Diode D₁ stellt eine konstante Gatespannung zur Verfügung und legt damit die Einschaltschwelle des PUT 5 fest. Der hochohmige Vorwiderstand R_{VZ} der Z-Diode D₁ stellt sicher, dass auch bei großen Eingangsspannungen kein zu großer Strom durch die Z-Diode D₁ fließt und hält somit auch die auftretende Verlustleistung klein. Die Eingangsspannung U_{HV} wird durch den Ohmschen Widerstand R_{VC} in einen Strom umgewandelt. Dieser Strom lädt den Kondensator C₁ mit der Zeitkonstanten (R_{VZ}•C₁) auf. Erreicht die Spannung am Kondensator C₁ die Schwellspannung am Eingang G des PUT, schaltet der PUT 5 durch und entlädt den Kondensator C₁ über die LED 6. Dabei sollte der Ohmsche Widerstand R_{VC} so groß bemessen sein, dass auch bei maximaler Eingangsspannung U_{HV} der Haltestrom des PUTs 5 nicht überschritten wird, da sonst der PUT 5 nicht wieder ausschalten würde. Der Betrieb als Oszillator wäre damit gestört. Die Oszillationsfrequenz wird durch die Zeitkonstante R_{VZ}•C₁ bestimmt. Aus der vorstehend beschriebenen Funktion ergeben sich die Zeitdiagramme der Spannung U_{C1} über den Kondensator C₁ sowie des Stroms i₆ durch die LED 6.

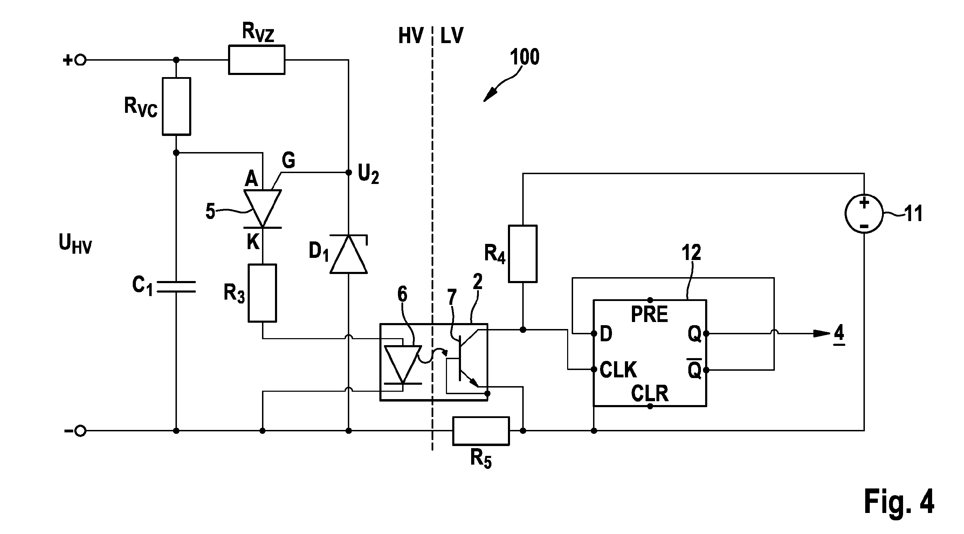

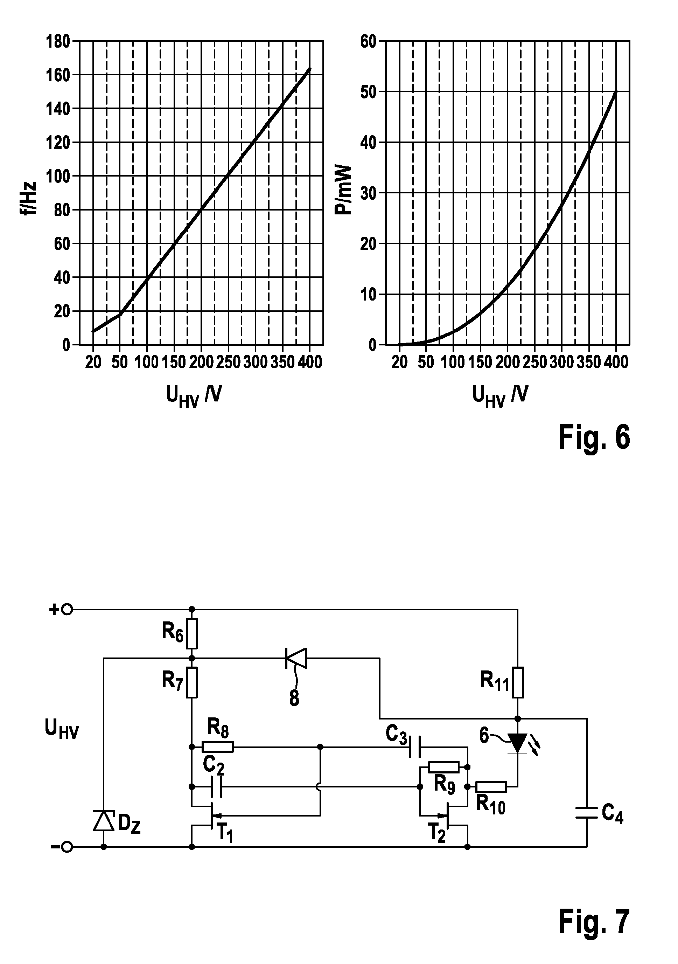

Figur 4 zeigt eine Schaltung zur Simulation eines Ausführungsbeispiels einer erfindungsgemäßen Vorrichtung 100, deren Hochvolt (HV)-Seite schaltungstechnisch mit der Hochvolt (HV)-Seite aus Figur 3 übereinstimmt. Zusätzlich sind die Dimensionierungen der elektrischen Bauteile wie folgt angegeben: Die Ohmschen Widerstände R_{VC} bzw. R_{VZ} betragen 20 MΩ bzw. 3 MΩ. Der dritte Ohmsche Widerstand R₃ hat einen Wert von 33 Ω. Die Kapazität C₁ beträgt 10 pF. Die Hochvolt (HV)-Seite ist zusätzlich zu einem Übertrager 2 über einen Ohmschen Widerstand R₅ in Höhe von 1 GΩ mit der Niedervolt (LV)-Seite verbunden. Eine erste Ausgangsklemme des Luftsensors 5 ist mit einem ersten Anschluss eines vierten Ohmschen Widerstandes R₄ von 10 kΩ und einem Clock-Eingang CLK eines Mikrocontrollers 12 elektrisch verbunden. Der vierte Ohmsche Widerstand R₄ ist zur Spannungsversorgung des Lichtsensors 7 über seinen zweiten Anschluss mit einer Gleichspannungsquelle 11 verbunden. Die Anschlüsse D und Q-"Querstrich" des Mikrocontrollers 12 sind elektrisch kurzgeschlossen. Der Ausgang Q des Mikrocontrollers 12 ist elektrisch mit einer Ausgabeeinheit 4 verbunden. Ein zweiter Ausgang des Lichtsensors 7 ist ebenso wie ein zweiter Anschluss der Versorgungsspannung 11 und ein Gehäuseanschluss des Mikrocontrollers 12 mit dem zweiten Anschluss desfünften Ohmschen Widerstandes R₅ verbunden. Bei der vorliegenden Dimensionierung beträgt die Frequenz bei 400 V Eingangsspannung ca. 160 Hz. Bei einer Eingangsspannung von 40 V beträgt die Frequenz ca. 16 Hz. Die Abhängigkeit der Frequenz von der Eingangsspannung ist zwischen ca. 40 V und 400 V linear, ließe sich also auf einfache Weise mit einem Mikrocontroller auswerten. Dieser Zusammenhang ist in Figur 6 (linkes Diagramm) dargestellt. Die Leistungsaufnahme ist spannungsabhängig und liegt bei entsprechender Dimensionierung zwischen einem Wert < 1 mW (bei 20 V) und einem Wert von 300 mW (bei 1000 V). Dieser Zusammenhang ist in Figur 6 (rechtes Diagramm) dargestellt.

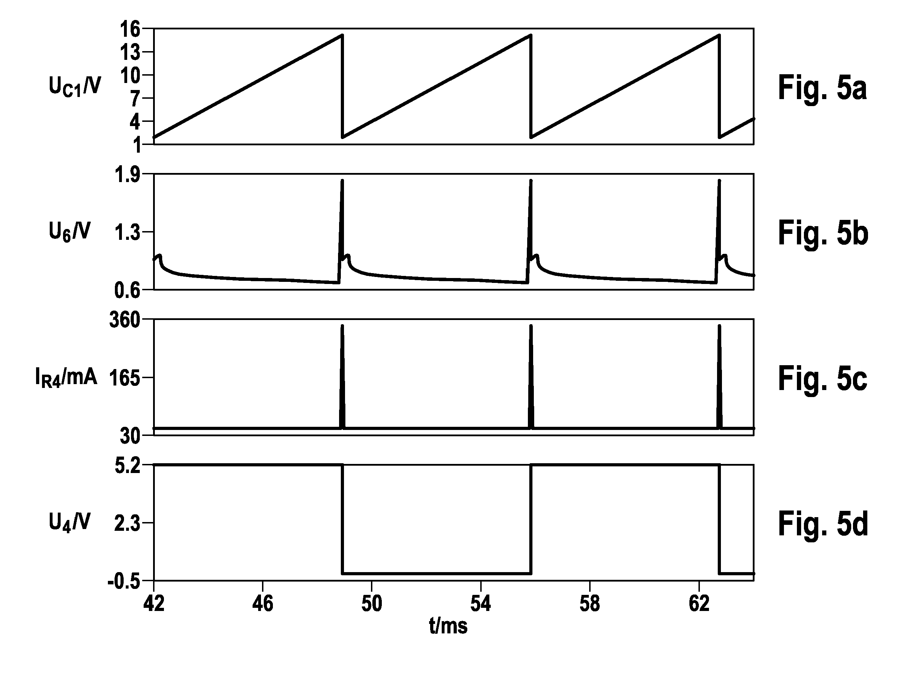

Figur 5 zeigt Simulationsgrößen über der Zeit t, welche aus der in Figur 4 gezeigten Modellschaltung einer Vorrichtung 100 ermittelt worden sind. Diagramm a) zeigt eine Sägezahnspannung U_{C1} über der Kapazität C₁. Diagramm b) zeigt die Spannung U₆ über der LED 6. Diagramm c) zeigt den Strom I_{R4} durch den vierten Ohmschen Widerstand R₄. Diagramm d) zeigt die elektrische Spannung U₄ über dem vierten Ohmschen Widerstand R₄.

Figur 7 zeigt ein Schaltbild einer alternativen Ausführungsform einer HV-Seite einer Vorrichtung 100 gemäß der vorliegenden Erfindung. Diese ist aus einem astabilen Multivibrator abgeleitet. An die Hochspannung U_{HV} ist ein erster Anschluss eines sechsten Ohmschen Widerstandes R₆ sowie ein erster Anschluss eines elften Ohmschen Widerstandes R₁₁ angeschlossen. Der zweite Anschluss des sechsten Ohmschen Widerstandes R₆ ist mit einem ersten Anschluss eines siebten Ohmschen Widerstandes R₇ verbunden, dessen zweiter Anschluss mit einem ersten Anschluss eines achten Ohmschen Widerstandes R₈ elektrisch verbunden ist. Zudem ist der siebte Ohmsche Widerstand R₇ über seinen zweiten Anschluss mit einem ersten Anschluss eines zweiten Kondensators C₂ sowie einen ersten Anschluss (Source) eines ersten Transistors T₁ angeschlossen. Ein zweiter Anschluss (Drain) des ersten Transistors T₁ ist mit dem Minuspol der Hochspannung U_{HV} elektrisch verbunden. Eine Zehnerdiode D_{Z} liegt zwischen dem zweiten Anschluss des sechsten Ohmschen Widerstandes R₆ und dem Minuspol der Hochspannung U_{HV}. Ein dritter Anschluss des ersten Transistors T₁ ist mit einem zweiten Anschluss des achten Ohmschen Widerstandes R₈ elektrisch verbunden. Eine Diode 8 ist an einem zweiten Anschluss des elften Ohmschen Widerstandes R₁₁ angeschlossen, so dass sie in Flussdurchlassrichtung zum zweiten Anschluss des sechsten Ohmschen Widerstandes R₆ führt. Ein erster Anschluss eines dritten Kondensators C₃ ist an den zweiten Anschluss des achten Ohmschen Widerstandes R₈ angeschlossen. Sein zweiter Anschluss ist mit einem zweiten Anschluss eines neunten Ohmschen Widerstandes R₉ elektrisch verbunden, dessen erster Anschluss am zweiten Anschluss des zweiten Kondensators C₂ angeschlossen ist. Beim zweiten Anschluss des zweiten Kondensators C₂ ist zudem ein Gateanschluss eines zweiten Transistors T₂ angeschlossen, dessen übrige Anschlüsse eingerichtet sind, den zweiten Anschluss des neunten Ohmschen Widerstandes R9 und den Minuspol der Hochspannung U_{HV} miteinander zu verbinden. Ein erster Anschluss eines zehnten Ohmschen Widerstandes R₁₀ ist am zweiten Anschluss eines neunten Ohmschen Widerstandes R₉ angeschlossen, wobei eine LED 6 den zweiten Anschluss des elften Ohmschen Widerstandes R₁₁ und den zweiten Anschluss des zehnten Ohmschen Widerstandes R₁₀ in Flussrichtung des zehnten Ohmschen Widerstandes R₁₀ verbindet. Der zweite Anschluss des elften Ohmschen Widerstandes R₁₁ ist zudem über einen vierten Kondensator C₄ mit dem Minuspol der Hochspannungsquelle U_{HV} elektrisch verbunden.

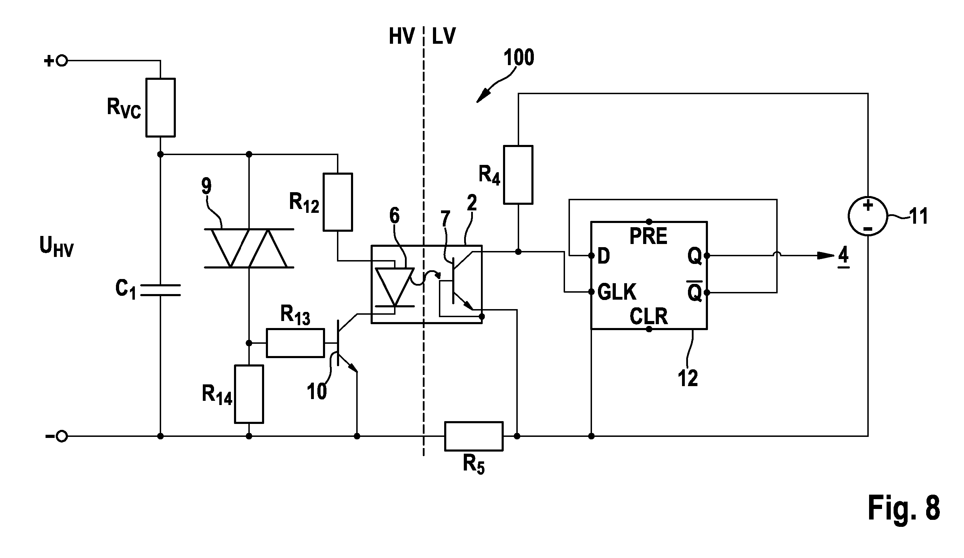

Figur 8 zeigt ein alternatives Ausführungsbeispiel einer Vorrichtung 100 gemäß der vorliegenden Erfindung in Form eines Schaltungsmodells zur Simulation seiner Funktion. Niederspannungs (LV)-seitig stimmt die Vorrichtung 100 mit der LV-Seite der in Figur 4 gezeigten Vorrichtung 100 überein. Hochspannungs (HV)-seitig ist der Pluspol + der Hochspannung U_{HV} mit einem ersten Anschluss eines Widerstandes R_{VC}, welcher einen Wert von 2 MΩ aufweist, elektrisch verbunden. Über einen ersten Kondensator C₁ ist der zweite Anschluss des Ohmschen Widerstandes R_{VC} mit dem Minuspol der Hochspannung U_{HV} verbunden. Der erste Kondensator C₁ weist eine Kapazität von 10 pF auf. Weiter ist ein erster Anschluss eines zwölften Ohmschen Widerstandes R₁₂, der einen Wert von 200 Ω aufweist, mit dem zweiten Anschluss des Ohmschen Widerstandes R_{VC} verbunden. Der zweite Anschluss des zwölften Ohmschen Widerstandes R₁₂ ist mit einem ersten Anschluss einer LED 6 verbunden, deren zweiter Anschluss mit einem Kollektoranschluss eines Transistors 10 verbunden ist. Ausgangsseitig (Emitter) ist der Transistor 10 mit dem Minuspol - der Hochspannung UHV verbunden. Der Basisanschluss des Transistors 10 ist über einen dreizehnten Ohmschen Widerstand R₁₃ mit einem Zweipol 9 verbunden, der zwei antiparallel geschaltete Dioden (auch "DIAC" genannt) umfasst. Der Zweipol 9 ist andererseits mit dem zweiten Anschluss des Ohmschen Widerstandes R_{VC} elektrisch verbunden. Zwischen dem Zweipol 9 und dem dreizehnten Ohmschen Widerstand R₁₃ ist ein vierzehnter Ohmscher Widerstand R₁₄, der einen Wert von 20 kΩ aufweist, angeschlossen, der andererseits mit dem Minuspol der elektrischen Hochspannung U_{HV} verbunden ist. Dabei stellt der Zweipol 9 einen Diac dar, der auch als "Zweirichtungs-Diode" bezeichnet wird. Die Strecke zwischen den Anschlüssen des Diac wird erst dann leitfähig, wenn die Spannung über dem Diac dessen Durchbruchspannung übersteigt.

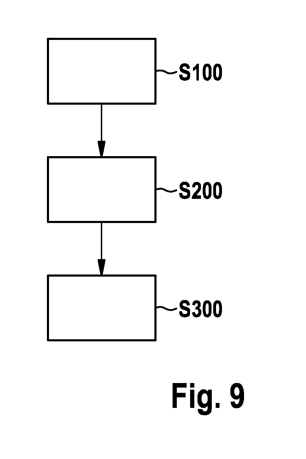

Figur 9 zeigt ein Flussdiagramm, veranschaulichend Schritte eines Ausführungsbeispiels eines erfindungsgemäßen Verfahrens. In Schritt S100 wird ein erstes Signal mit einer Frequenz proportional der Gleichspannung auf einer Hochvolt (HV)-Seite eines isolierten Systems erzeugt. Dies kann beispielsweise durch einen VCO 5 erfolgen. Anschließend wird das erzeugte erste Signal in Schritt S200 galvanisch isoliert auf eine Niedervolt (LV)-Seite des Systems übertragen. Anschließend wird im Schritt S300 die Gleichspannung aus der Frequenz des übertragenen Signals ermittelt. Erfindungsgemäß kann hierbei auf eine Versorgungsspannung für eine Hochvolt (HV)-seitige Erzeugung des ersten Signals verzichtet werden, weshalb zur Ausführung dieses Verfahrens geeignete Einrichtungen besonders einfach und kostengünstig aufgebaut sein und betrieben werden können.

Auch wenn die erfindungsgemäßen Aspekte und vorteilhaften Ausführungsformen anhand der in Verbindung mit den beigefügten Zeichnungsfiguren erläuterten Ausführungsbeispiele im Detail beschrieben worden sind, sind für den Fachmann Modifikationen und Kombinationen von Merkmalen der dargestellten Ausführungsbeispiele möglich, ohne den Bereich der vorliegenden Erfindung zu verlassen, deren Schutzbereich durch die beigefügten Ansprüche definiert wird.

## Patentansprüche

1. Verfahren zum Ermitteln einer Gleichspannung (U_{HV}) eines galvanisch isolierten Systems umfassend die Schritte
- Erzeugen (S100) eines ersten Signals (U₆) mit einer Frequenz proportional der Gleichspannung (U_{HV}) auf einer Hochvolt (HV)-Seite des Systems,
- galvanisch getrenntes Übertragen (S200) des ersten Signals (U6) auf eine Niedervolt (LV)-Seite des Systems, und
- Ermitteln (S300) der Gleichspannung (UHV) aus der Frequenz des übertragenen Signals.

2. Verfahren nach Anspruch 1, wobei zum Erzeugen des ersten Signals (U₆) ausschließlich elektrische Energie der Hochvolt (HV)-Seite, insbesondere der Gleichspannung (U_{HV}) selbst, verwendet wird.

3. Vorrichtung (100) zum Ermitteln einer Gleichspannung (U_{HV}) umfassend
- einen spannungsabhängigen Frequenzgenerator (5) zum Erzeugen eines ersten Signals (U₆) mit einer Frequenz proportional der Gleichspannung (U_{HV}),
- einen Übertrager (2) zum galvanisch getrennten Übertragen des ersten Signals (U6),
- eine Signalverarbeitungseinheit (3) zum Ermitteln der Gleichspannung (U_{HV}) aus der Frequenz des übertragenen ersten Signals (U₆), wobei der spannungsabhängige Frequenzgenerator (5) eingerichtet ist, aus der Gleichspannung (U_{HV}) mit elektrischer Energie versorgt zu werden.

4. Vorrichtung nach Anspruch 3, wobei der spannungsabhängige Frequenzgenerator (5) und/oder der Übertrager (2) ausschließlich aus der Gleichspannung (U_{HV}) mit elektrischer Energie versorgt wird.

5. Vorrichtung nach Anspruch 3 oder 4, wobei der Übertrager (2) eingerichtet ist, das erste Signal (U₆) kapazitiv und/oder induktiv und/oder optisch zu übertragen.

6. Vorrichtung nach einem der Ansprüche 3 bis 5, wobei
- ein Eingang des spannungsabhängigen Frequenzgenerators (5) eingerichtet ist, mit der zu messenden Gleichspannung (UHV) beaufschlagt zu werden, und
- ein Ausgang des spannungsabhängigen Frequenzgenerators (5) eingerichtet ist, ein Eingangssignal des Übertragers (2) bereitzustellen.

7. Vorrichtung nach einem der Ansprüche 3 bis 6, wobei die Signalverarbeitungseinheit (3) einen Mikrocontroller umfasst.

8. Vorrichtung nach einem der Ansprüche 3 bis 7, weiter umfassend eine Ausgabeeinheit (4), welche eingerichtet ist, einen Anwender über die ermittelte Gleichspannung (U_{HV}) zu informieren.

9. Verfahren nach einem der vorstehenden Ansprüche 1 oder 2 oder Vorrichtung nach einem der Ansprüche 3 bis 8, wobei die Gleichspannung (U_{HV}) eine Hochvolt-Spannung eines Energiespeichers eines elektrisch antreibbaren Fortbewegungsmittels oder eine Hochvolt-Spannung eines Photovoltaik-Moduls ist.
